# EUROPEAN PATENT APPLICATION

(11) **EP 4 340 008 A1**
(43) Date of publication of application: **20.03.2024**
(21) Application number: 23197579.8
(22) Date of filing: 15.09.2023
(51) Int. Cl.: H01L 21/67, C23C 16/44, H01L 21/324

(54) **HIGH PRESSURE PROCESSING APPARATUS FOR THE MANUFACTURING OF SEMICONDUCTORS WAFERS**

(30) Priority: 16.09.2022 KR 20220117353
(71) Applicant: HPSP Co., Ltd., Suwon-si, Gyeonggi-do (KR)
(72) Inventor: LIM, Kun Young, Suwon-si, Gyeonggi-do (KR); Min, Bin hong, Suwon-si, Gyeonggi-do (KR)
(74) Representative: von Bülow & Tamada

(57) **Abstract**

Provided is a high pressure processing apparatus including: a first chamber accommodating an object to be processed; a second chamber surrounding the first chamber and heating the first chamber; a third chamber including a 3-1-th chamber surrounding a portion of the second chamber and a 3-2-th chamber surrounding another portion of the second chamber; and a supply module supplying a process gas for processing the object in the first chamber at a first pressure, supplying a protection gas to a space between the second chamber and the first chamber at a second pressure set in relation to the first pressure, and supplying a defense gas to a space between each of the 3-1-th chamber and the 3-2-th chamber and the second chamber at a third pressure lower than the first pressure and the second pressure and higher than an external pressure of the third chamber to block external air from being introduced into the third chamber.

## Description

### BACKGROUND

### Field

The present disclosure relates to a wafer processing apparatus used to process an object in a high pressure environment.

### Description of the Related Art

In general, various processing may be performed on a semiconductor wafer during a manufacturing process of a semiconductor device. As an example of such processing, there is oxidation, nitridation, silicide, ion implantation, chemical vapor deposition (CVD) processes, or the like. There is also a hydrogen or deuterium heat treatment process to improve an interface property of the semiconductor device.

A gas used for the processing may be supplied to a chamber at a high pressure higher than atmospheric pressure and act on the semiconductor wafer. If the gas leaks, ignition as well as contamination of a surrounding area may occur.

As a temperature in the processing process is increased, such a risk may also be increased. If the temperature in the processing is a spontaneous ignition temperature of the gas or more, the risk of the ignition due to the gas leak may become even greater.

### SUMMARY

An object of the present disclosure is to provide a high pressure processing apparatus which may structurally prevent a risk of ignition due to a gas leak during a processing process even if the process is performed at a high temperature.

According to an embodiment of the present disclosure, a high pressure processing apparatus includes: a first chamber accommodating an object to be processed; a second chamber surrounding the first chamber and heating the first chamber; a third chamber including a 3-1-th chamber surrounding a portion of the second chamber and a 3-2-th chamber surrounding another portion of the second chamber; and a supply module supplying a process gas for processing the object in the first chamber at a first pressure, supplying a protection gas to a space between the second chamber and the first chamber at a second pressure set in relation to the first pressure, and supplying a defense gas to a space between each of the 3-1-th chamber and the 3-2-th chamber and the second chamber at a third pressure lower than the first pressure and the second pressure and higher than an external pressure of the third chamber to block external air from being introduced into the third chamber.

The 3-1-th chamber and the 3-2-th chamber may occupy areas independent of each other.

The third pressure may have a value biased toward the external pressure than the first pressure or the second pressure.

The apparatus may further include a control module controlling an operation of the supply module, wherein the control module controls the supply module to supply the defense gas to the 3-1-th chamber and the 3-2-th chamber according to different standards.

The apparatus may further include a detection module including a first sensor detecting an environment in the 3-1-th chamber and a second sensor detecting an environment in the 3-2-th chamber, wherein the control module controls the supply module based on a detection result of the detection module.

The first sensor may include a pressure gauge, and the control module may control the supply module to inject the defense gas for a pressure in the 3-1-th chamber to reach a set pressure when the pressure in the 3-1-th chamber that is detected by the pressure gauge is lower than the set pressure.

The second sensor may include a gas detector, and the control module may control the supply module to inject the defense gas for oxygen concentration in the 3-2-th chamber to reach set oxygen concentration when the oxygen concentration in the 3-2-th chamber that is detected by the gas detector is higher than the set oxygen concentration.

The apparatus may further include: an exhaust module communicating with the 3-1-th chamber; and a control module controlling the exhaust module, wherein the control module controls the exhaust module to prevent the defense gas supplied to the 3-1-th chamber from being exhausted while the processing of the object is normally performed in the first chamber.

The apparatus may further include: a detection module disposed in the 3-1-th chamber; an exhaust module communicating with the first chamber, the second chamber, and the 3-1-th chamber; and a control module controlling the exhaust module, wherein the control module controls the exhaust module to exhaust a gas in at least one of the first chamber, the second chamber, and the 3-1-th chamber when determining that the gas leaks based on a detection result of the detection module.

The control module may control the supply module to supply the defense gas to the 3-1-th chamber to dilute the process gas when the gas in the 3-1-th chamber is exhausted.

The supply module may include a gas regulation supplier supplying the defense gas to the 3-1-th chamber while regulating a flow rate of the defense gas; and an emergency open/close supplier supplying the defense gas to the 3-1-th chamber at a maximum set flow rate when the gas in the 3-1-th chamber is exhausted.

The detection module may include at least one of a pressure gauge and a gas detector, and the control module may determine that the gas leaks when a pressure of the gas in the 3-1-th chamber that is detected by the pressure gauge is higher than a set pressure or the gas detector detects the process gas.

The object may include a semiconductor wafer, the process gas may include at least one of hydrogen, deuterium, fluorine, ammonia, and chlorine, and at least one of the protection gas and the defense gas may include an inert gas.

According to another embodiment of the present disclosure, a high pressure processing apparatus includes: a first chamber accommodating an object to be processed; a second chamber surrounding the first chamber; a third chamber surrounding the second chamber; a supply module supplying a process gas for processing the object in the first chamber at a first pressure, supplying a protection gas to a space between the second chamber and the first chamber at a second pressure set in relation to the first pressure, and supplying a defense gas to a space between the third chamber and the second chamber at a third pressure higher than an external pressure of the third chamber to prevent influx of external air into the third chamber; and a heating module disposed in the second chamber and heating the process gas to a temperature higher than an ignition point of the process gas.

The third pressure may be lower than the first pressure or the second pressure, and have a value biased toward the external pressure than the first pressure or the second pressure.

The apparatus may further include a control module controlling the supply module, wherein the third chamber includes a third upper chamber surrounding an upper portion of the second chamber, and a third lower chamber surrounding a lower portion of the second chamber, and the control module controls the supply module to inject the defense gas into the third upper chamber and the third lower chamber according to different criteria.

The apparatus may further include a detection module including a first sensor detecting an environment in the third upper chamber and a second sensor detecting an environment in the third lower chamber, wherein the control module controls the supply module based on a detection result of the detection module.

The first sensor may include a pressure gauge, and the control module may control the supply module to inject the defense gas for a pressurein the third upper chamber to reach a set pressure when the pressure in the third upper chamber that is detected by the pressure gauge is lower than the set pressure.

The second sensor may include a gas detector, and the control module may control the supply module to inject the defense gas for oxygen concentration in the third lower chamber to reach set oxygen concentration when the oxygen concentration in the third lower chamber that is detected by the gas detector is higher than the set oxygen concentration.

The third upper chamber and the third lower chamber may occupy areas independent of each other.

The apparatus may further include: an exhaust module communicating with the third chamber; and a control module controlling the exhaust module, wherein the control module controls the exhaust module to prevent the defense gas supplied to the third chamber from being exhausted while the processing of the object is normally performed in the first chamber.

The apparatus may further include: a detection module disposed in the third chamber; an exhaust module communicating with the first chamber, the second chamber, and the third chamber; and a control module controlling the exhaust module, wherein the control module controls the exhaust module to exhaust a gas in at least one of the first chamber, the second chamber, and the third chamber when determining that the gas leaks based on a detection result of the detection module.

The control module may control the supply module to supply the defense gas to the third chamber to dilute the process gas when the gas in the third chamber is exhausted.

The supply module may include a gas regulation supplier supplying the defense gas to the third chamber while regulating a flow rate of the defense gas; and an emergency open/close supplier supplying the defense gas to the third chamber at a maximum set flow rate when the gas in the third chamber is exhausted.

The detection module may include at least one of a pressure gauge and a gas detector, and the control module may determine that the gas leaks when a pressure of the gas in the third chamber that is detected by the pressure gauge is higher than a set pressure or the gas detector detects the process gas.

The object may include a semiconductor wafer, the process gas may include at least one of hydrogen, deuterium, fluorine, ammonia, and chlorine, and at least one of the protection gas and the defense gas may include an inert gas.

### BRIEF DESCRIPTION OF THE DRAWINGS

FIG. 1 is a conceptual diagram of a high pressure processing apparatus according to an embodiment of the present disclosure.
FIG. 2 is a block diagram for explaining a control configuration of the high pressure processing apparatus of FIG. 1.
FIG. 3 is a conceptual diagram of a high pressure processing apparatus according to another embodiment of the present disclosure.
FIG. 4 is a flowchart for explaining a control method of a gas in a third upper chamber.
FIG. 5 is a flowchart for explaining a control method of a gas in a third lower chamber.

### DETAILED DESCRIPTION

Hereinafter, a high pressure processing apparatus according to embodiments of the present disclosure is described in detail with reference to the accompanying drawings. Throughout the present disclosure, components that are the same as or similar to each other are denoted by reference numerals that are the same as or similar to each other, and a description thereof is replaced by the first description, even in a different embodiment.

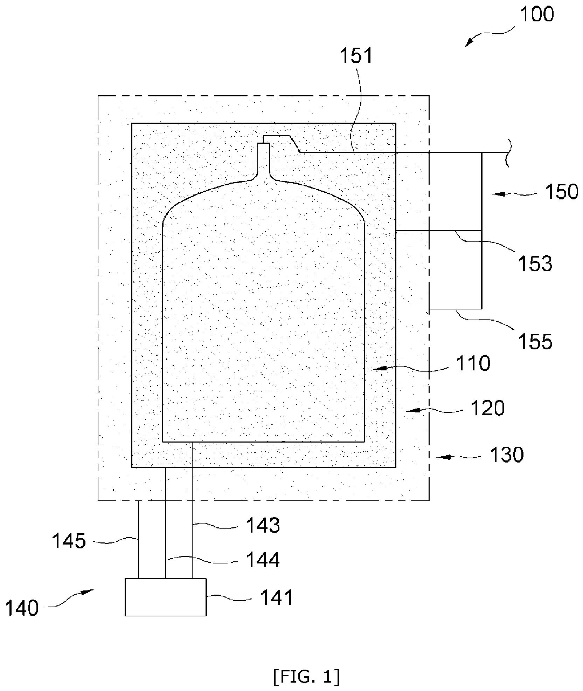

FIG. 1 is a conceptual diagram of a high pressure processing apparatus 100 according to an embodiment of the present disclosure.

Referring to this drawing, the high pressure processing apparatus 100 may include a first chamber 110, a second chamber 120, a third chamber 130, a supply module 140, and an exhaust module 150.

The first chamber 110 may have an accommodation space for accommodating an object to be processed. The first chamber 110 may be made of a non-metallic material, for example, quartz, to reduce contamination in a high pressure and high temperature working environment. Although simplified in the drawing, a door (not shown) for opening the accommodation space may be positioned at the bottom of the first chamber 110. The accommodation space may be opened as the door descends, and the object may be injected into the first chamber 110 while being mounted on a holder (not shown). As a heater (not shown) disposed outside the first chamber 110 is operated, the first chamber 110 may be heated up to hundreds to thousands of degrees Celsius. The object may be, for example, a semiconductor wafer. In this case, the holder may be a wafer boat which may stack the semiconductor wafers in a plurality of layers.

The second chamber 120 may entirely surround the first chamber 110. Therefore, an opening (or the bottom) of the first chamber 110 and the door closing the opening may be entirely surrounded by the second chamber 120. Unlike the first chamber 110, the second chamber 120 is free from a contamination problem, and may thus be made of a metal material. The second chamber 120 may have an inner space for accommodating the first chamber 110. The second chamber 120 may also have a door at a lower portion, and the door of the second chamber 120 may also descend and be opened when the door of the first chamber 110 is opened.

The third chamber 130 may entirely surround the second chamber 120. Like the second chamber 120, the third chamber 130 is also free from the contamination problem, and may thus be made of the metal material. The third chamber 130 may be operated at a lower pressure compared to the first and second chambers 110 and 120 operated at a higher pressure. To show this feature, the third chamber 130 is drawn with a different type of line from the first and second chambers 110 and 120.

In another alternative embodiment, the third chamber 130 may surround only a portion of the second chamber 120. The portion of the second chamber 120 may be its upper, lower, left, right, or corner portion, or a combination thereof. The third chamber 130 may surround a portion (e.g., connection part) particularly vulnerable to a gas leak among the portions of the second chamber 120. For example, the third chamber 130 may entirely surround an opening (or the bottom) of the second chamber 120 and a door closing the opening as a part of the second chamber 120.

The supply module 140 may supply a gas to the first chamber 110, the second chamber 120, and the third chamber 130. The supply module 140 may include a gas supply box 141 serving as a source of the gas and communicating with a utility line (or a gas supply line) of a semiconductor factory. The gas supply box 141 may selectively provide a process gas for processing the object such as hydrogen/deuterium, fluorine, ammonia, chlorine, or nitrogen to the first chamber 110 through a first gas line 143. The gas supply box 141 may provide a protection gas such as nitrogen or argon, which is an inert gas, to the second chamber 120 through a second gas line 144. The protection gas injected into the second chamber 120 may be specifically supplied to a space between the second chamber 120 and the first chamber 110. The gas supply box 141 may provide a defense gas to the third chamber 130 through a third gas line 145. The defense gas also may include the inert gas. The defense gas injected into the third chamber 130 may be specifically supplied to a space between the third chamber 130 and the second chamber 120. The defense gas supplied to the third chamber 130 may be the same kind as or a different kind of gas from the protection gas supplied to the second chamber 120.

The process gas supplied to the first chamber 110 or the protection gas supplied to the second chamber 120 may be supplied to form a pressure higher than atmospheric pressure, for example, a high pressure ranging from several atmospheric pressures to tens of atmospheric pressures. When the pressure of the process gas is a first pressure and the protection gas is a second pressure, the second pressure may be set in association with the first pressure. For example, the second pressure may be set to be substantially equal to or slightly greater than the first pressure. Such a pressure relationship may prevent process gas leak from first chamber 110 and damage to the first chamber 110. The pressure of the defense gas supplied to the third chamber 130 may be defined as a third pressure, and may be different from the first pressure or the second pressure. The third pressure may be higher than an external pressure of the third chamber 130 (usually, the atmospheric pressure) and lower than the first pressure or the second pressure. In detail, the third pressure may have a value biased toward the external pressure, and may be somewhat higher than the atmospheric pressure. For example, the third pressure may be a pressure higher by tens to hundreds of Pa than the atmospheric pressure. The third pressure may be only a fraction or a few tenths of the first pressure or the second pressure. The third pressure may be set to block external air (or oxygen) from being introduced into the third chamber 130.

The exhaust module 150 may exhaust the process gas, the protection gas, and the defense gas. A first exhausted line 151 may communicate with the upper portion of the first chamber 110 to exhaust the process gas from the first chamber 110. The first exhaust line 151 may extend outside the second chamber 120 and the third chamber 130. A valve (not shown) for controlling discharge of the process gas may be installed in the first exhausted line 151. Similarly, a second exhausted line 153/a third exhausted line 155 communicating with each of the second chamber 120/the third chamber 130 may be provided to discharge the protection gas/the defense gas therefrom. These exhausted lines 151, 153, and 155 may be integrated with one another, and the process gas may thus be diluted with the protection gas and the defense gas during an exhaust process, thereby lowering its concentration.

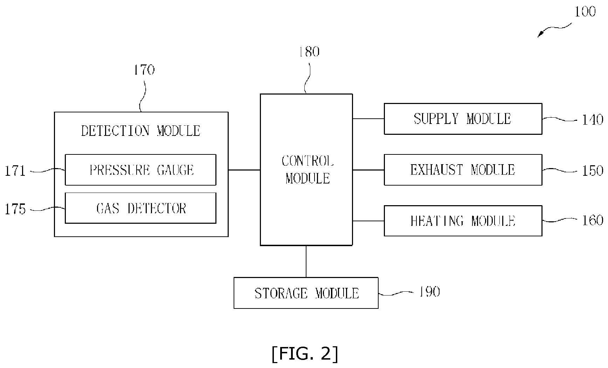

The description describes a control configuration of the high pressure processing apparatus 100 with reference to FIG. 2. FIG. 2 is a block diagram for explaining the control configuration of the high pressure processing apparatus of FIG. 1.

Referring to this drawing (and FIG. 1), the high pressure processing apparatus 100 may further include a heating module 160, a detection module 170, a control module 180, and a storage module 190 in addition to the supply module 140, the exhaust module 150, and the like, described above.

The heating module 160 may include the above-mentioned heater. The heater may be classified as a component of the second chamber 120, and may also be classified as a separate component, the heating module 160, as shown in this drawing. The heating module 160, specifically the heater, may be disposed in the second chamber 120. The heater may generate heat toward the first chamber 110, thereby heating the process gas to a temperature higher than its ignition point. For example, when hydrogen is used as the process gas, hydrogen may be heated to its ignition point of 575 °C or more.

The detection module 170 may detect an environment of each chamber. The detection module 170 may employ a pressure gauge 171 and a gas detector 175. The pressure gauge 171 may be individually installed in each of the first chamber 110 to the third chamber 130. The gas detector 175 may be installed in the third chamber 130, and detect leaking gas (in detail, an active gas such as hydrogen) or oxygen introduced from the outside during the processing process.

The control module 180 may control the supply module 140, the exhaust module 150, and the heating module 160. The control module 180 may control the supply module 140 or the like based on a detection result of the detection module 170.

The storage module 190 may store data, programs, or the like that the control module 180 may refer to for the control.

Through this configuration, the control module 180 may supply the process gas, the protection gas, or the defense gas to the chambers 110, 120, and 130, or cause the gas to be exhausted from the chambers 110, 120, and 130. The control module 180 may control the supply module 140 for the former, and the control module 180 may control the exhaust module 150 for the latter. The defense gas supplied to the third chamber 130 may not be exhausted while a wafer processing process in the first chamber 110 is normally performed.

The control module 180 may determine whether the gas leaks based on the detect result of the detection module 170. In detail, the control module 180 may determine that the gas leaks when the pressure of the gas in the third chamber 130 that is detected by the pressure gauge 171 is higher than a set pressure, the gas detector 175 installed in the third chamber 130 detects the process gas, or the like.

When determining that the gas leaks, the control module 180 may stop the processing process and operate the exhaust module 150. The exhaust module 150 may be operated to exhaust a gas in at least one of the first chamber 110, the second chamber 120, and the third chamber 130.

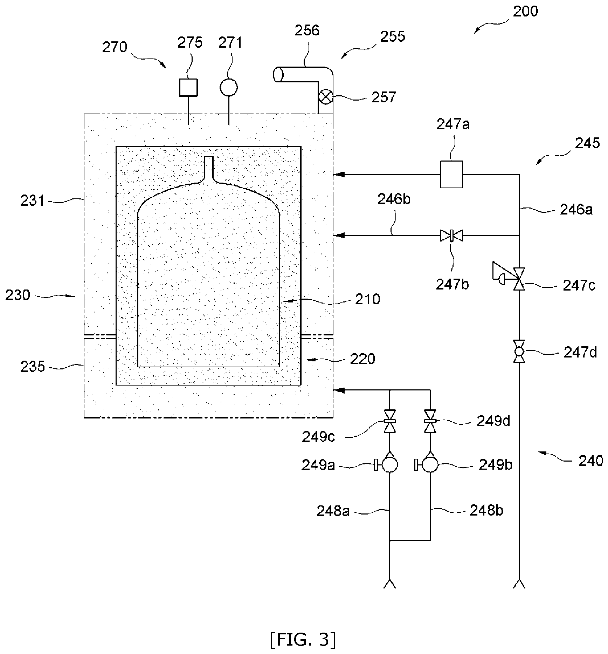

A type different from the high pressure processing apparatus 100 is described with reference to FIGS. 3 to 5.

First, FIG. 3 is a conceptual diagram of a high pressure processing apparatus according to another embodiment of the present disclosure.

Referring to this drawing, a high pressure processing apparatus 200 is substantially the same as the high pressure processing apparatus 100 of the previous embodiment. However, the apparatus 200 is somewhat different from the apparatus 100 in dividing a third chamber 230 into a 3-1-th chamber 231 and a 3-2-th chamber 235, and specifying configurations of the supply module 240 and the exhaust module 250 in relation to the third chamber 230. The configurations of the supply module 240 and the exhaust module 250 in relation to the first chamber 210 and the second chamber 220 are omitted in this drawing and replaced with the illustration in FIG. 1.

The 3-1-th chamber 231 and the 3-2-th chamber 235 may occupy areas independent of each other. For example, the 3-1-th chamber 231 may surround a portion of the second chamber 220, specifically, the upper portion. Accordingly, the 3-1-th chamber 231 may also be referred to as the third upper chamber 231. The third upper chamber 231 may mainly surround the gas lines 143, 144, and 145 (see FIG. 1 above). On the other hand, the 3-2-th chamber 235 may surround another portion of the second chamber 220, specifically, the lower portion. Accordingly, the 3-2th chamber 235 may also be referred to as the third lower chamber 235. The third lower chamber 235 may entirely surround the opening of the second chamber 220, where the semiconductor wafer (not shown) is injected, and the door closing this chamber.

The third upper chamber 231 does not need to be open, and may thus be operated in a closed manner. On the other hand, the third lower chamber 235 has a door (not shown) to inject or discharge the semiconductor wafer, and may thus be opened as needed. Therefore, the third lower chamber 235 may be operated in an optional open manner.

The supply module 240 may include a regulation line 246a and a bypass line 246b that communicate with the third upper chamber 231 to supply air to the third upper chamber 231. The regulation line 246a may be directly connected to the utility line of the semiconductor factory, and the bypass line 246b may branch from the regulation line 246a. This configuration is different from the previous embodiment in which the third gas line 145 is connected to the utility line through the gas supply box 141 (see FIG. 1). The regulation line 246a may be directly connected to the utility line, thus distributing a risk of gas supply disruption caused by malfunction of the gas supply box 141.

A gas regulation supplier 247a may be installed in the regulation line 246a. The gas regulation supplier 247a may supply the defense gas to the third upper chamber 231 in a normal operation mode. The gas regulation supplier 247a may serve to maintain the set pressure of the gas in the third upper chamber 231 while regulating a supply flow rate of the defense gas. To this end, the gas regulation supplier 247a may be operated based on a pressure detected by a pressure gauge 271.

An emergency open/close supplier 247b may be installed in the bypass line 246b. The emergency open/close supplier 247b does not regulate the supply flow rate of the defense gas. The emergency open/close charger 247b may supply the defense gas to the third upper chamber 231 at the maximum set flow rate in an emergency operation mode (or a mode for exhausting the gas from the third upper chamber 231). The emergency open/close charger 247b may also remain closed in the normal operation mode. The gas leaking in the third upper chamber 231 may be exhausted more quickly as the defense gas in large quantities is supplied to the third upper chamber 231.

A regulator 247c and a manual valve 247d may also be installed in the regulation line 246a. The regulator 247c may regulate the flow rate of the defense gas introduced from the utility line to change the maximum set flow rate. The manual valve 247d is a manual valve to regulate a flow of the defense gas itself through the regulation line 246a.

To supply air to the third lower chamber 235, the supply module 240 may include a main regulation line 248a and an auxiliary regulation line 248b that respectively communicate with the third lower chamber 235. The defense gas may be supplied to the third lower chamber 235 basically through the main regulation line 248a. When there is a limit to the supply of the defense gas through the main regulation line 248a, the defense gas may be additionally supplied to the third lower chamber 235 through the auxiliary regulation line 248b. A target supply amount of the defense gas may be reached more quickly as a gas regulation supplier 249b is operated together with a gas regulation supplier 249a.

The main regulation line 248a and the auxiliary regulation line 248b may each have the gas regulation supplies 249a and 249b to regulate the gas supply amount. The gas regulation supplier 249a of the main regulation line 248a may supply the defense gas at a larger flow rate than the gas regulation supplier 249b of the auxiliary regulation line 248b. The gas regulation supplies 249a and 249b may be, for example, mass flow controllers (MFCs). Open/close valves 249c and 249d for opening and closing a flow path itself may also be installed in the main regulation line 248a and the auxiliary regulation line 248b.

The description describes an exhaust line 255 communicating with the third upper chamber 231 in relation to the exhaust module 250. A duct 256 included in the exhaust line 255 may communicate with a utility line (or a gas exhaust line) of the semiconductor factory. A gate valve 257 may be installed in the duct 256. When the gas in the third upper chamber 231 is required to be exhausted, the gate valve 257 may be opened under control of the control module 180 (see FIG. 2). An exhaust line with a similar configuration as the exhaust line 255 may be installed in the third lower chamber 235.

The detection module 270 may include the pressure gauge 271 and the gas detector 275 to detect an environment in the third upper chamber 231. These components may be installed in the third upper chamber 231, and may be collectively referred to as a first sensor. These sensors may also be installed in the third lower chamber 235 to detect the environment in the third lower chamber 235. In this case, the gauge and the detector, installed in the third lower chamber 235, may be collectively referred to as a second sensor.

The control module 180 (see FIG. 2) may control the supply module 240 to supply the defense gas to the third upper chamber 231 and the third lower chamber 235 according to different standards. In detail, a standard for the third upper chamber 231 may be maintaining its pressure to the set pressure. On the other hand, a standard for the third lower chamber 235 may be maintaining its oxygen concentration to set concentration. The control module 180 may perform the control based on detection results of the first sensor and the second sensor. Hereinafter, the description describes this configuration in detail.

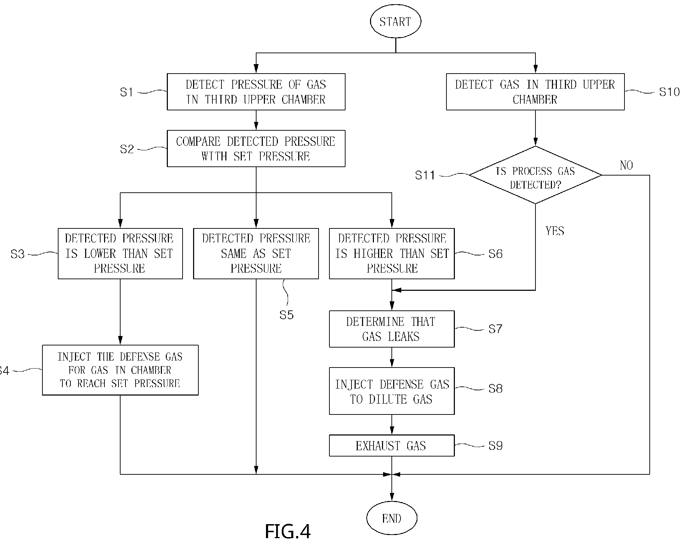

FIG. 4 is a flowchart for explaining a control method of the gas in the third upper chamber.

Referring to this drawing (and FIGS. 2 and 3), the pressure of the gas in the third upper chamber 231 may be detected by the pressure gauge 271 (S1).

The control module 180 may compare the detected pressure with the set pressure set for the third upper chamber 231 (S2).

When the detected pressure is lower than the set pressure (S3), the control module 180 may control the supply module 240 to additionally inject the defense gas (S4). In detail, the control module 180 may operate the gas regulation supplier 247a for the pressure of the gas in the third upper chamber 231 to reach the set pressure.

When the detected pressure is the same as the set pressure (S5), this state may be maintained. The control module 180 does not operate the supply module 240.

When the detected pressure is more than the set pressure (S6), the control module 180 may determine that the gas leaks (S7). The reason is that the pressure of the gas in the third upper chamber 231 is increased as the process gas in the first chamber 210 or the protection gas in the second chamber 220 leaks and penetrates into the third upper chamber 231. In response to the gas leak, the emergency open/close supplier 247b may be operated to inject the defense gas into the third upper chamber 231 at the maximum set flow rate. The injection of the defense gas may dilute the concentration of the leaking gas (S8). The diluted leaking gas may be exhausted through the duct 256 by opening the gate valve 257 (S9). When the gas in the third upper chamber 231 is exhausted, the gas in the first chamber 110 and the second chamber 120 may also be exhausted by the exhaust lines 151 and 153 (see FIG. 1). The gas in the third lower chamber 235 may not be exhausted because a degree of the gas leak is not significant. However, this gas may also be exhausted for a strict management.

The gas leak determination (S7), the dilution (S8), and the exhaust (S9) may also be made by detecting the gas in the third upper chamber 231 (S10). When the gas detector 275 detects the process gas (S11), the control module 180 may determine that the gas leaks (S7). In this case, the dilution (S8) and the exhaust (S9) as described before may be sequentially performed.

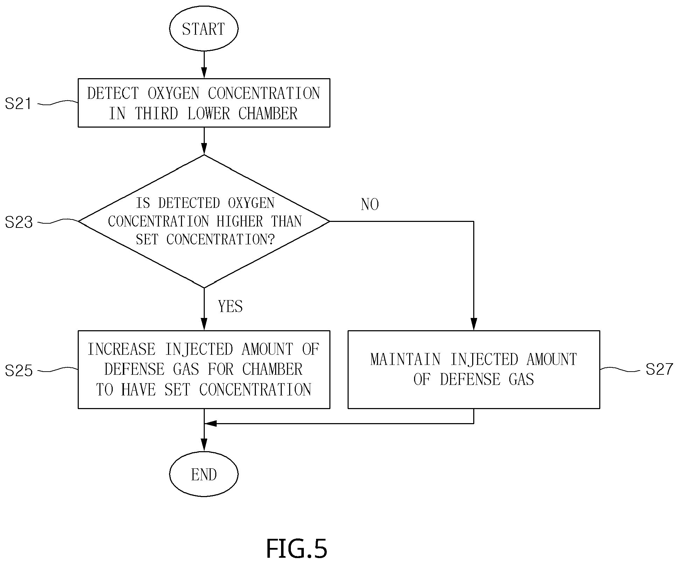

FIG. 5 is a flowchart for explaining a control method of the gas in the third lower chamber.

Referring to this drawing, the gas detector 275 (see FIG. 3) among the second sensors may detect the oxygen concentration (S21).

When determining that the detected oxygen concentration is higher than the set oxygen concentration (S23), the control module 180 may increase the injected amount of the defense gas into the third lower chamber 235. To this end, the control module 180 may control a required amount of the defense gas to be additionally supplied to the third lower chamber 235 through the main regulation line 248a.

When requiring the additional supply of a large amount of the defense gas, the control module 180 may control the defense gas to be supplied to the third lower chamber 235 not only through the main regulation line 248a but also through the auxiliary regulation line 248b. As the defense gas is supplied thereto, the oxygen concentration in the third lower chamber 235 may reach the set oxygen concentration (S25).

When determining that the detected oxygen concentration is the set oxygen concentration or less (S23), the control module 180 may maintain a current injected amount of the defense gas (S27). To this end, the control module 180 may maintain the flow rate of the defense gas injected through the main regulation line 248a. The third lower chamber 235 may constantly exhaust a predetermined amount of gas. In this case, the third lower chamber 235 may maintain a pressure slightly higher than the atmospheric pressure even when the defense gas is continuously injected thereto.

The high pressure processing apparatus as described above is not limited to the configurations and operation methods of the embodiments described above. The embodiments described above may be configured so that various modifications are made by selective combinations of all or some of the respective embodiments.

For example, the description does not describe the gas leak in the third lower chamber 235 and a response thereto. However, the same operation described for the third upper chamber 231 may also be performed for the third lower chamber 235.

As set forth above, the high pressure processing apparatus according to the present disclosure configured as above may include the first chamber accommodating the object to be processed and supplied with the process gas at the first pressure, the second chamber surrounding the first chamber and supplied with the protection gas at the second pressure set in relation to the first pressure, and the third chamber surrounding the second chamber and blocking the introduction of external air thereinto by receiving the defense gas at the third pressure higher than the external pressure. Therefore, the third chamber may structurally prevent the risk of ignition when the leaking process gas meets oxygen in external air even when the process gas leaks from the first chamber.

## Claims

1. A high pressure processing apparatus, the apparatus comprising:
a first chamber accommodating an object to be processed;
a second chamber surrounding the first chamber and heating the first chamber;
a third chamber including a 3-1-th chamber surrounding a portion of the second chamber and a 3-2-th chamber surrounding another portion of the second chamber; and
a supply module supplying a process gas for processing the object in the first chamber at a first pressure,
supplying a protection gas to a space between the second chamber and the first chamber at a second pressure set in relation to the first pressure, and
supplying a defense gas to a space between each of the 3-1-th chamber and the 3-2-th chamber and the second chamber at a third pressure lower than the first pressure and the second pressure and higher than an external pressure of the third chamber to block external air from being introduced into the third chamber.

2. The apparatus of claim 1, wherein the 3-1-th chamber and the 3-2-th chamber occupy areas independent of each other.

3. The apparatus of claim 1, wherein the third pressure has a value biased toward the external pressure than the first pressure or the second pressure.

4. The apparatus of claim 1, further comprising a control module controlling an operation of the supply module,
wherein the control module controls the supply module to supply the defense gas to the 3-1-th chamber and the 3-2-th chamber according to different standards.

5. The apparatus of claim 4, further comprising a detection module including a first sensor detecting an environment in the 3-1-th chamber and a second sensor detecting an environment in the 3-2-th chamber,
wherein the control module controls the supply module based on a detection result of the detection module.

6. The apparatus of claim 5, wherein the first sensor includes a pressure gauge, and
the control module controls the supply module to inject the defense gas for a pressure in the 3-1-th chamber to reach a set pressure when the pressure in the 3-1-th chamber that is detected by the pressure gauge is lower than the set pressure.

7. The apparatus of claim 5, wherein the second sensor includes a gas detector, and
the control module controls the supply module to inject the defense gas for oxygen concentration in the 3-2-th chamber to reach set oxygen concentration when the oxygen concentration in the 3-2-th chamber that is detected by the gas detector is higher than the set oxygen concentration.

8. The apparatus of claim 1, further comprising:
an exhaust module communicating with the 3-1-th chamber; and
a control module controlling the exhaust module,
wherein the control module controls the exhaust module to prevent the defense gas supplied to the 3-1-th chamber from being exhausted while the processing of the object is normally performed in the first chamber.

9. The apparatus of claim 1, further comprising:
a detection module disposed in the 3-1-th chamber;
an exhaust module communicating with the first chamber, the second chamber, and the 3-1-th chamber; and
a control module controlling the exhaust module,
wherein the control module controls the exhaust module to exhaust a gas in at least one of the first chamber, the second chamber, and the 3-1-th chamber when determining that the gas leaks based on a detection result of the detection module.

10. The apparatus of claim 9, wherein the control module controls the supply module to supply the defense gas to the 3-1-th chamber to dilute the process gas when the gas in the 3-1-th chamber is exhausted.

11. The apparatus of claim 10, wherein the supply module includes
a gas regulation supplier supplying the defense gas to the 3-1-th chamber while regulating a flow rate of the defense gas; and
an emergency open/close supplier supplying the defense gas to the 3-1-th chamber at a maximum set flow rate when the gas in the 3-1-th chamber is exhausted.

12. The apparatus of claim 9, wherein the detection module includes at least one of a pressure gauge and a gas detector, and
the control module determines that the gas leaks when a pressure of the gas in the 3-1-th chamber that is detected by the pressure gauge is higher than a set pressure or the gas detector detects the process gas.

13. The apparatus of claim 1, wherein the object includes a semiconductor wafer,
the process gas includes at least one of hydrogen, deuterium, fluorine, ammonia, and chlorine, and
at least one of the protection gas and the defense gas includes an inert gas.

14. A high pressure processing apparatus, the apparatus comprising:
a first chamber accommodating an object to be processed;
a second chamber surrounding the first chamber;
a third chamber surrounding the second chamber;
a supply module supplying a process gas for processing the object in the first chamber at a first pressure,
supplying a protection gas to a space between the second chamber and the first chamber at a second pressure set in relation to the first pressure, and
supplying a defense gas to a space between the third chamber and the second chamber at a third pressure higher than an external pressure of the third chamber to block external air from being introduced into the third chamber; and
a heating module disposed in the second chamber and heating the process gas to a temperature higher than an ignition point of the process gas.

15. The apparatus of claim 14, wherein the third pressure is lower than the first pressure or the second pressure, and has a value biased toward the external pressure than the first pressure or the second pressure.

16. The apparatus of claim 14, further comprising a control module controlling the supply module,
wherein the third chamber includes
a third upper chamber surrounding an upper portion of the second chamber, and
a third lower chamber surrounding a lower portion of the second chamber, and
the control module controls the supply module to inject the defense gas into the third upper chamber and the third lower chamber according to different standards.

17. The apparatus of claim 16, further comprising a detection module including a first sensor detecting an environment in the third upper chamber and a second sensor detecting an environment in the third lower chamber,
wherein the control module controls the supply module based on a detection result of the detection module.

18. The apparatus of claim 17, wherein the first sensor includes a pressure gauge, and
the control module controls the supply module to inject the defense gas for a pressure in the third upper chamber to reach a set pressure when the pressure in the third upper chamber that is detected by the pressure gauge is lower than the set pressure.

19. The apparatus of claim 17, wherein the second sensor includes a gas detector, and
the control module controls the supply module to inject the defense gas for oxygen concentration in the third lower chamber to reach set oxygen concentration when the oxygen concentration in the third lower chamber that is detected by the gas detector is higher than the set oxygen concentration.

20. The apparatus of claim 16, wherein the third upper chamber and the third lower chamber occupy areas independent of each other.

21. The apparatus of claim 14, further comprising:
an exhaust module communicating with the third chamber; and
a control module controlling the exhaust module,
wherein the control module controls the exhaust module to prevent the defense gas supplied to the third chamber from being exhausted while the processing of the object is normally performed in the first chamber.

22. The apparatus of claim 14, further comprising:
a detection module disposed in the third chamber;
an exhaust module communicating with the first chamber, the second chamber, and the third chamber; and
a control module controlling the exhaust module,
wherein the control module controls the exhaust module to exhaust a gas in at least one of the first chamber, the second chamber, and the third chamber when determining that the gas leaks based on a detection result of the detection module.

23. The apparatus of claim 22, wherein the control module controls the supply module to supply the defense gas to the third chamber to dilute the process gas when the gas in the third chamber is exhausted.

24. The apparatus of claim 23, wherein the supply module includes
a gas regulation supplier supplying the defense gas to the third chamber while regulating a flow rate of the defense gas; and
an emergency open/close supplier supplying the defense gas to the third chamber at a maximum set flow rate when the gas in the third chamber is exhausted.

25. The apparatus of claim 22, wherein the detection module includes at least one of a pressure gauge and a gas detector, and
the control module determines that the gas leaks when a pressure of the gas in the third chamber that is detected by the pressure gauge is higher than a set pressure or the gas detector detects the process gas.

26. The apparatus of claim 14, wherein the object includes a semiconductor wafer,
the process gas includes at least one of hydrogen, deuterium, fluorine, ammonia, and chlorine, and
at least one of the protection gas and the defense gas includes an inert gas.
